(19) Europäisches Patentamt
European Patent Office
Office européen des brevets

(11) **EP 2 506 390 B1**

(12) **EUROPEAN PATENT SPECIFICATION**

(45) Date of publication and mention
of the grant of the patent:
**16.03.2016 Bulletin 2016/11**

(51) Int Cl.:
*H02J 7/00* *(2006.01)*        *B60L 11/18* *(2006.01)*
*G01R 31/36* *(2006.01)*       *H02J 7/34* *(2006.01)*

(21) Application number: **12161346.7**

(22) Date of filing: **26.03.2012**

(54) **Battery voltage controller**

Batteriespannungssteuerung

Contrôleur de tension de batterie

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.03.2011   JP 2011074933**

(43) Date of publication of application:
**03.10.2012   Bulletin 2012/40**

(73) Proprietor: **Keihin Corporation
Shinjuku-ku, Tokyo (JP)**

(72) Inventor: **Kamata, Seiji
Tochigi-ken (JP)**

(74) Representative: **Ilgart, Jean-Christophe et al
Brevalex
95, rue d'Amsterdam
75378 Paris Cedex 8 (FR)**

(56) References cited:
**US-A1- 2004 246 635     US-A1- 2006 261 677
US-A1- 2009 309 545**

**Description**

BACKGROUND OF THE INVENTION

Field of the Invention

The present invention relates to a battery voltage controller.

Description of the Related Art

As known, a vehicle, such as an electric car or a hybrid car, is provided with a motor, and a high-voltage and high-capacity battery that supplies power to the motor. The battery includes multiple battery cells connected in series. The battery cell includes a lithium-ion battery, a nickel-metal hydride battery, or the like. In related art, a voltage balance control of monitoring and equalizing cell voltages of the battery cells is performed to maintain the performance of the battery.

For example, Japanese Patent Laid-Open Publication No. 2008-21589 and No. 2010-88179 disclose technique of equalizing cell voltages. According to the related art, discharge circuits are connected in parallel to each of the battery cells. Each discharge circuit includes a bypass resistor and a switching element which are connected in series. The switching element of the discharge circuit connected to the battery cell in the overcharged state is controlled to be on-state. Thereby, the battery cell in the overcharged state is discharged, thereby equalizing the cell voltages.

In the related art, however, part of electric charge stored in the battery cell in the overcharged state is discharged by the discharge circuits in order to equalize the cell voltages. In other words, part of electric energy stored in the battery cell is wastefully consumed as thermal energy. In view of energy efficiency, there has been demand for improvement.

The document US 2009/309545 discloses the preamble of claim 1.

The document US 2004/246635 discloses a voltage detection circuit, a controller and a charge transfer capacitors. The voltage is not detected by charging voltage detection capacitors.

The present invention has been made in view of the above situations. An object of the present invention is to provide a battery voltage controller that can enhance the energy efficiency at the time of voltage balance control.

SUMMARY

To solve the above problem, a battery voltage controller according to one aspect of the present invention includes, but is not limited to: a plurality of voltage detection circuits; a voltage controller; and a charge transfer circuit. The voltage detection circuits respectively include a plurality of voltage detection capacitors. Each of the voltage detection circuits is configured to output a voltage between terminals of one of the voltage detection capacitors after the voltage detection capacitors are respectively charged by a plurality of battery cells. The voltage controller is configured to obtain output voltages of the voltage detection circuits as results of voltage detection for the battery cells, and perform voltage balance control of the battery cells based on the results of the voltage detection. The charge transfer circuit is configured to transfer electric charge from one of the voltage detection capacitors to a charge transfer capacitor according to control by the voltage controller, and transfer electric charge from the charge transfer capacitor to another one of the voltage detection capacitors.

If a first battery cell of the battery cells is higher in cell voltage than other battery cells of the battery cells as the results of the voltage detection, the voltage controller may be configured to determine, as a charge transferring source, a first voltage detection capacitor of the voltage detection capacitors which is charged by the first battery cell, and control the charge transfer circuit to transfer electric charge from the first voltage detection capacitor to the charge transfer capacitor.

The voltage controller may be configured to monitor a voltage between terminals of the charge transfer capacitor. If a voltage between terminals of the first voltage detection capacitor is higher than the voltage between the terminals of the charge transfer capacitor, the voltage controller may be configured to control the charge transfer circuit to transfer the electric charge from the first voltage detection capacitor to the charge transfer capacitor.

If a second battery cell of the battery cells is lower in cell voltage than other battery cells of the battery cells as the results of the voltage detection, the voltage controller may be configured to determine, as a charge transferring destination, a second voltage detection capacitor of the voltage detection capacitors which is charged by the second battery cell, and control the charge transfer circuit to transfer electric charge from the charge transfer capacitor to the second voltage detection capacitor.

The voltage controller may be configured to monitor a voltage between terminals of the charge transfer capacitor. If a voltage between terminals of the second voltage detection capacitor is lower than the voltage between the terminals of the charge transfer capacitor, the voltage controller may be configured to control the charge transfer circuit to transfer the electric charge from the charge transfer capacitor to the second voltage detection capacitor.

One of the terminals of the charge transfer capacitor which is on a high potential side may be connected to a power voltage line via a regeneration switch. The voltage controller may be configured to control the regeneration switch to be on-state if the voltage controller determines, based on the results of the voltage detection, that all of the battery cells are fully charged.

According to the present invention, part of electric energy stored in the battery cell, which has been wastefully consumed as thermal energy, that is, electric charge stored in the battery cell, can be transferred from a battery cell with a high cell voltage (high SOC) to a battery cell with a low cell voltage (low SOC), thereby equalizing cell voltages. Accordingly, it is possible to enhance the energy efficiency at the time of voltage balance control.

BRIEF DESCRIPTION OF THE DRAWINGS

The above features and advantages of the present invention will be more apparent from the following description of certain preferred embodiments taken in conjunction with the accompanying drawings, in which:

FIG. 1 schematically illustrates a configuration of a battery voltage controller 1 according to an embodiment of the present invention; and
FIGS. 2A to 4B illustrate operation of the battery voltage controller 1.

DETAILED DESCRIPTION OF THE PREFERRED EMBODIMENTS

The present invention will now be described herein with reference to illustrative embodiments. The accompanying drawings explain a battery voltage controller. The size, the thickness, and the like of each illustrated portion might be different from those of each portion of an actual battery voltage controller.

Those skilled in the art will recognize that many alternative embodiments can be accomplished using the teachings of the present invention and that the present invention is not limited to the embodiments illustrated herein for explanatory purposes.

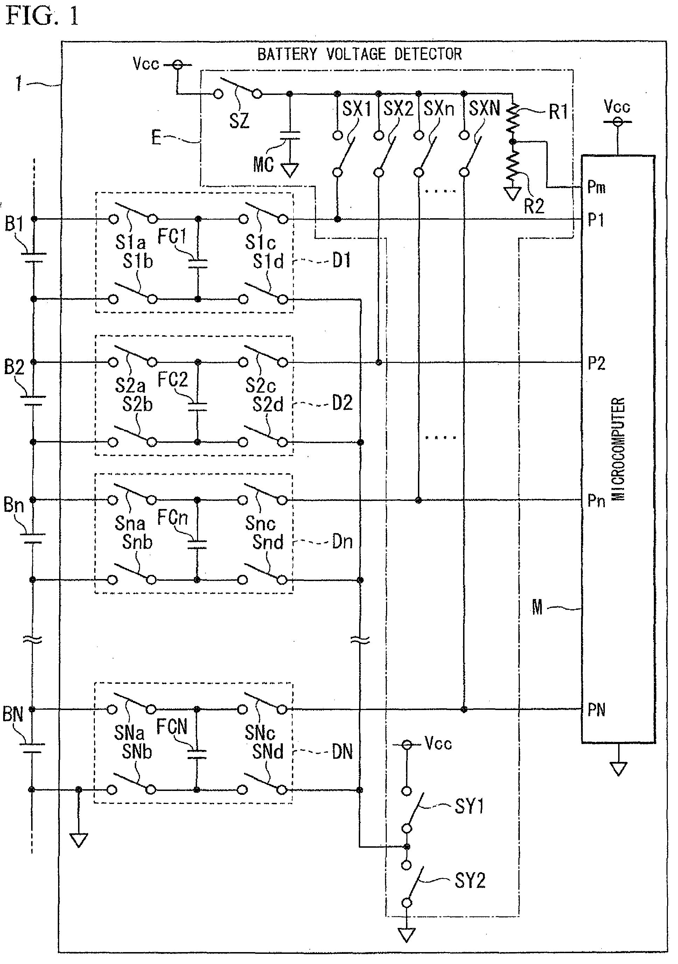

FIG. 1 schematically illustrates a battery voltage controller 1 according to an embodiment of the present invention. As shown in FIG 1, the battery voltage controller 1 is an ECU (Electronic Control Unit) that detects cell voltages of N battery cells B1 to BN connected in series (for example, N=12), and performs voltage balance control of the battery cells B1 to BN based on results of the cell voltage detection. The battery voltage controller 1 includes: cell voltage detection circuits D1 to DN provided respectively for the battery cells B1 to BN; a charge transfer circuit E; and a microcomputer (voltage controller) M.

Each of the cell voltage detection circuits D1 to DN has the same circuit configuration. In other words, the n-th cell voltage detection circuit (n is an integer of 1 to N), which is appended with a reference symbol Dn, includes: a flying capacitor (voltage detection capacitor) FCn; a first input switch Sna; a second input switch Snb; a first output switch Snc; and a second output switch Snd.

The flying capacitor FCn is a capacitor that temporarily stores electric charge of a voltage between terminals (cell voltage) of the n-th battery cell Bn. The first input switch Sna, the second input switch Snb, and the first output switch Snc, and the second output switch Snd are switching elements such as MOSFET (Metal Oxide Semiconductor-Field Effect Transistor), the on/off-state of which are controlled by the microcomputer M.

The charge transfer circuit E includes: a charge transfer capacitor MC; N first charge transfer switches SX1 to SXN; two second charge switches SY1 and SY2; a regeneration switch SZ; and two voltage dividing resistors R1 and R2. The charge transfer capacitor MC is a capacitor to be used for transferring electric charge between flying capacitors. The first charge transfer switches SX1 to SXN, the second charge transfer switches SY1 and SY2, and the regeneration switch SZ are switching elements such as MOSFET, the on/off-state of which are controlled by the microcomputer M.

One terminal of the flying capacitor FCn is connected to a positive electrode terminal of the battery cell Bn via the first input switch Sna, and is connected to the n-th cell voltage input port Pn of the microcomputer M via the first output switch Snc. Additionally, the one terminal of the flying capacitor FCn is connected to one terminal of the charge transfer capacitor MC via the first output switch Snc and the n-th first charge transfer switch SXn.

The other terminal of the flying capacitor FCn is connected to a negative electrode terminal of the battery cell Bn via the second input switch Snb, and is connected to a power voltage line (for example, a 5V-Vcc line) in the battery voltage controller 1 via the second output switch Snd and the second charge transfer switch SY1. The other terminal of the flying capacitor FCn is connected to a common potential line (for example, a ground line) in the battery voltage controller 1 via the second output switch Snd and the second charge transfer switch SY2.

The one terminal of the charge transfer capacitor MC is connected to the first charge transfer switches SX1 to SXN. Additionally, the one terminal of the charge transfer capacitor MC is connected to the Vcc line via the regeneration switch SZ, and is connected to one terminal of the voltage dividing resistor R1. The other terminal of the charge transfer capacitor MC is connected to the ground line. The voltage dividing resistors R1 and R2 are connected in series. One terminal of the voltage dividing resistor R2 is connected to the ground line. Additionally, a terminal of the voltage dividing resistor R2, which is on the high potential side thereof (i.e., the terminal connected to the voltage dividing resistor R1) is connected to a monitor voltage input port Pm of the microcomputer M.

Although the connection state between the n-th cell voltage detection circuit Dn and the charge transfer circuit E has been explained above, the connection state is common to all the cell voltage detection circuits D1 to DN. For example, regarding the first cell voltage detection circuit D1 (n=1), one terminal of the flying capacitor FC1 is connected to the positive electrode terminal of the battery cell B1 via the first input switch S1a, and is connected to the cell voltage input port P1 of the microcomputer M via the first output switch S1c. Additionally, the one terminal of the flying capacitor FC1 is connected to one terminal of the charge transfer capacitor MC via the first output switch S1c and the first charge transfer switch SX1.

The other terminal of the flying capacitor FC1 is connected to the negative electrode terminal of the battery cell B1 via the second input switch S1b, and is connected to the Vcc line via the second output switch S1d and the second charge transfer switch SY1. Additionally, the other terminal of the flying capacitor FC1 is connected to the ground line via the second output switch S1d and the second charge transfer switch SY2. The same connection state applies to the other cell voltage detection circuits D2 to DN (may substitute a different number in n), and therefore explanations thereof are omitted here.

As will be explained in detail later, under switch control of the microcomputer M, the cell voltage detection circuit Dn having the aforementioned configuration outputs a voltage V_FCn between the terminals of the flying capacitor FCn to the cell voltage input port Pn of the microcomputer M after the battery cell Bn charges the flying capacitor FCn (which is common to all the cell voltage detection circuits D1 to DN). Additionally, under the switch control of the microcomputer M, the charge transfer circuit E transfers electric charge from a flying capacitor as a charge transferring source to the charge transfer capacitor MC, and thereafter from the charge transfer capacitor MC to a flying capacitor as a charge transferring destination.

The microcomputer M is a microcomputer including a memory such as a ROM or a RAM, a CPU (Central Processing Unit), an A/D conversion circuit, an input/output interface, and the like. The microcomputer M controls on/off-state of each switch to obtain, as the results of the voltage detection for the respective battery cells B 1 to BN, output voltages of the respective cell voltage detection circuits D1 to DN (i.e., the voltage between terminals of each of the flying capacitors FC1 to FCN). Based on the results of the voltage detection, the microcomputer M performs voltage balance control of the battery cells B 1 to BN.

Hereinafter, operation of the battery voltage controller 1 having the aforementioned configuration is explained.

(Cell Voltage Detection Operation)

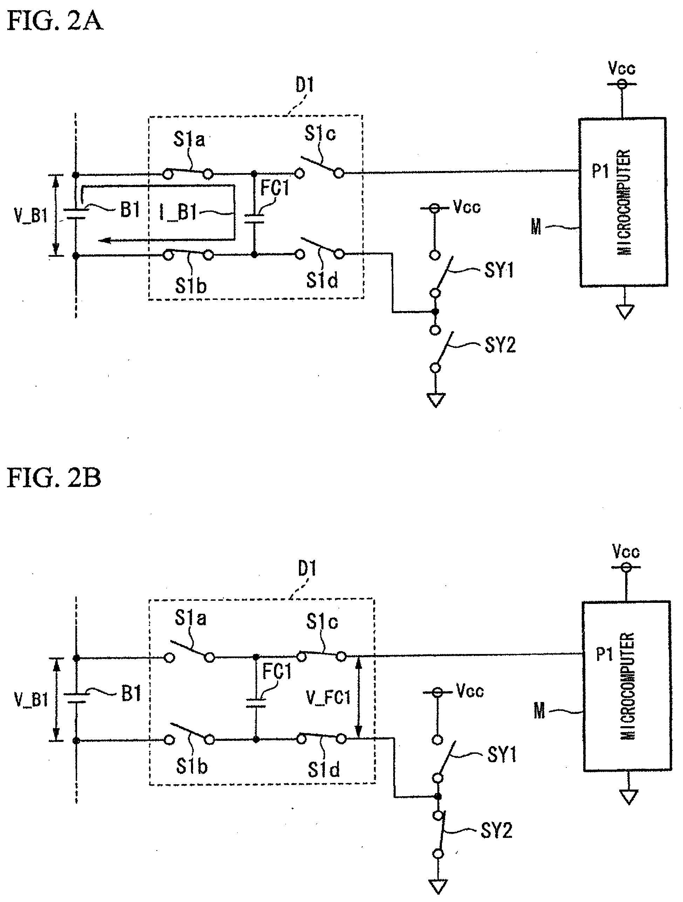

First, cell voltage detection operation of the battery voltage controller 1 is explained hereinafter. FIGS. 2A and 2B illustrate on/off-state of each switch at the time of the cell voltage detection by the respective battery cells B1 to BN. For simplification of explanations, only the first battery cell B1, the cell voltage detection circuit D1, the second charge transfer switches SY1 and SY2, and the microcomputer M are shown in FIGS. 2A and 2B, the state of each switch of the cell voltage detection circuits D1 to DN at the time of the cell voltage detection is the same.

As shown in FIG. 2A, the microcomputer M first controls the first input switch S1a and the second input switch S1b of the cell voltage detection circuit D1 to be on-state (all the other switches are off-state). Thereby, the flying capacitor FC1 of the cell voltage detection circuit D1 is connected in parallel to the battery cell B1, and thus is charged by a charging current I_B1 as indicated by an arrow shown in FIG. 2A. When the voltage V_FC1 between the terminals of the flying capacitor FC1 becomes equal to the voltage V_B1 between the terminals of the battery cell B1 (cell voltage), the flying capacitor FC1 enters a fully-charged state and the charging is completed.

When the charging of the flying capacitor FC1 by the battery cell B1 is completed, the microcomputer M controls the first input switch S1a and the second input switch S1b of the cell voltage detection circuit D1 to be off-state. Additionally, the microcomputer M controls the first output switch Sic, the second output switch S1d, and the second charge transfer switch SY2 to be on-state, as shown in FIG 2B. Thereby, one terminal of the flying capacitor FC1 is connected to the cell voltage input port P1 of the microcomputer M. Additionally, the other terminal of the flying capacitor FC1 is connected to the ground line. Consequently, the voltage V_FC1 between the terminals of the flying capacitor FC1 is output to the cell voltage input port P1 of the microcomputer M.

The microcomputer M obtains the input voltage of the cell voltage input port P1 (i.e., the voltage V_FC1 between the terminals of the flying capacitor FC1) as the cell voltage V_B1 of the first battery cell B1. Then, the microcomputer M causes the A/D conversion circuit to convert the cell voltage V_B1 into digital data that can be processed by the CPU. Then, the microcomputer M stores, as the result of the cell voltage detection, the digital data in an internal memory (for example, RAM). The microcomputer M performs the aforementioned switch control and the signal process on all the cell voltage detection circuits D1 to DN, thereby obtaining the cell voltage detection results (V_B1 to V_BN) for the respective voltage cells B1 to BN.

(Voltage Balance Control Operation)

Hereinafter, voltage balance control operation of the battery voltage controller 1 is explained. Based on the cell voltage detection results (V_B1 to V_BN) for the respective voltage cells B1 to BN which are stored in the internal memory, the microcomputer M determines whether or not there is a battery cell higher in cell voltage (SOC) than other battery cells. If there is a battery cell higher in cell voltage than other battery cells, the microcomputer M determines, as a charge transferring source, a flying capacitor charged by that battery cell with the high cell voltage. Hereinafter, explanations are given under the assumption that the flying capacitor FC1 is determined as the charge transferring source.

Then, the microcomputer M obtains, as a monitor voltage, an input voltage of the monitor voltage input port Pm (voltage Vm between the terminals of the voltage dividing resistor R2). Then, the microcomputer M causes the A/D conversion circuit to convert the monitor voltage Vm into digital data that can be processed by the CPU. Then, the microcomputer M calculates a voltage V_MC between the terminals of the charge transfer capacitor MC from the monitor voltage Vm by the following formula (1) where r1 denotes a resistance value of the voltage dividing resistor R1, and r2 denotes a resistance value of the voltage dividing resistor R2.

$$V\_MC = (r1+r2) \cdot Vm/r2 \qquad\qquad (1)$$

The microcomputer M compares the voltage V_MC between the terminals of the charge transfer capacitor MC calculated in the above manner to the voltage V_FC1 between the terminals of the flying capacitor FC1 determined as the charge transferring source (i.e., the cell voltage V_B1). If V_FC1 is higher than V_MC, the microcomputer M controls the charge transfer circuit E to transfer electric charge from the flying capacitor FC1 determined as the charge transferring source to the charge transfer capacitor MC.

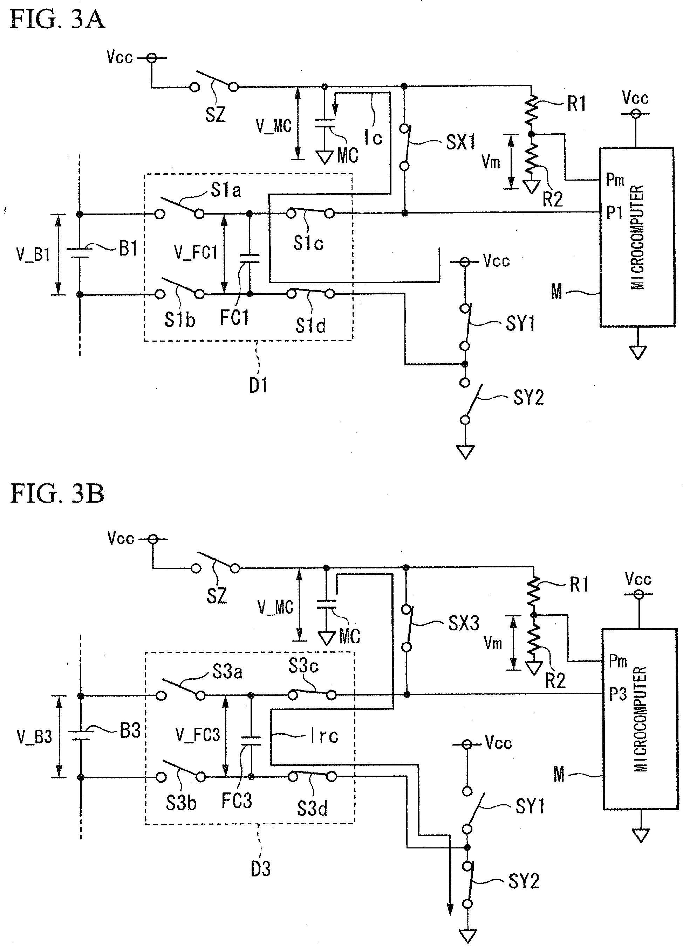

Specifically, if V_FC1 is higher than V_MC, the microcomputer M controls the first charge transfer switch SX1 and the second charge transfer switch SY1 of the charge transfer circuit E to be on-state, and controls the second charge transfer switch SY2 to be off-state, as shown in FIG. 3A. Thereby, one terminal of the flying capacitor FC1 is connected to the charge transfer capacitor MC, and the other terminal of the flying capacitor FC1 is connected to the Vcc line. At this time, the electric charge stored in the flying capacitor FC1 is transferred to the charge transfer capacitor MC, the charge transfer capacitor MC is charged by a charging current Ic as indicated by an arrow shown in FIG. 3A.

On the other hand, if there is a battery cell lower in cell voltage (SOC) than other battery cells, the microcomputer M determines, as a charge transferring destination, a flying capacitor charged by that battery cell with the low cell voltage. Hereinafter, explanations are given under the assumption that the flying capacitor FC3 is determined as the charge transferring destination.

The microcomputer M compares the voltage V_MC between the terminals of the charge transferring capacitor MC calculated in the above manner to the voltage V-FC3 between the terminals of the flying capacitor FC3 determined as the charge transferring destination (i.e., the cell voltage V_B3). If V_FC3 is lower than V_MC, the microcomputer M controls the charge transfer circuit E to transfer electric charge from the charge transfer capacitor MC to the flying capacitor FC3 determined as the charge transferring destination.

Specifically, if V_FC3 is lower than V_MC, the microcomputer M controls the first charge transfer switch SX3 and the second charge transfer switch SY2 of the charge transfer circuit E to be on-state, and controls the second charge transfer switch SY1 to be off-state, as shown in FIG. 3B. Thereby, one terminal of the flying capacitor FC3 is connected to the charge transfer capacitor MC, and the other terminal of the flying capacitor FC3 is connected to the ground line. At this time, the electric charge stored in the charge transfer capacitor MC is transferred to the flying capacitor FC3, and thereby the flying capacitor FC3 is charged by a charging current Irc as indicated by an arrow shown in FIG 3B.

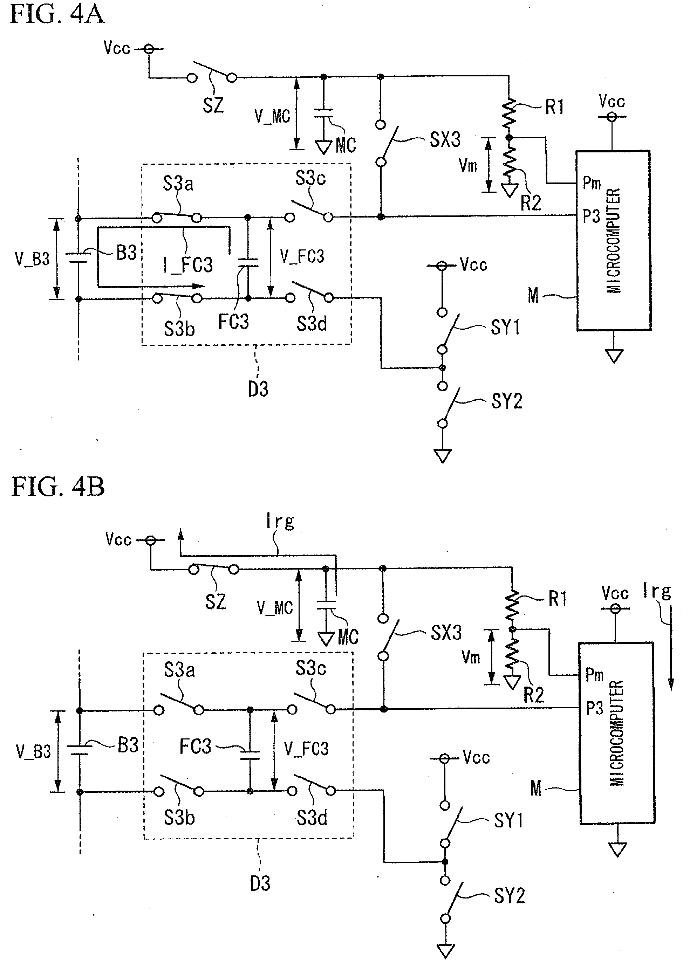

After the charging, the voltage V_FC3 between the terminals of the charged flying capacitor FC3 is higher than the cell voltage V_B3 of the battery cell B3. For this reason, if the next cell voltage detection operation is performed in which the first input switch S3a and the second input switch S3b of the cell voltage detection circuit D3 are controlled to be on-state (other switches are off-state), the battery cell B3 is charged by a charging current I_FC3 as indicated by an arrow shown in FIG 4A, thereby increasing the cell voltage V_B3 of the battery cell B3 (i.e., equalizing cell voltages).

As explained above, according to the present embodiment, part of the electric energy of a battery cell which has been wastefully consumed in the related art, that is, the electric charge stored in a battery cell, can be transferred from a battery cell with a high cell voltage (SOC) to a battery cell with a low cell voltage (SOC) using the flying capacitors FC 1 to FCN and the charge transfer capacitor MC, thereby equalizing the cell voltages. Therefore, it is possible to enhance the energy efficiency at the time of voltage balance control.

Additionally, if the microcomputer M determines, based on the cell voltage detection results (V_B1 to V_BN) of the respective battery cells B1 to BN stored in the internal memory, that the all the battery cells B1 to BN are in the fully-charged state (i.e., if there is no need to perform voltage balance control), the microcomputer M controls the regeneration circuit switch SZ to be on-state. Thereby, one terminal of the charge transfer capacitor MC is connected to the Vcc line, and a regeneration current Irg flows in the microcomputer M as indicated by an arrow shown in FIG 4B. In other words, if there is no need to perform voltage balance control, the electric charge stored in the charge transfer capacitor MC, that is, electric energy, is supplied to the Vcc line, thereby reducing power consumption of the battery voltage controller 1.

It is apparent that the present invention is not limited to the above embodiments, and may be modified and changed without departing from the scope and spirit of the invention. For example, the charge transfer circuit E having the circuit configuration as shown in FIG 1 has been taken as an example in the above embodiment. However, any circuit configuration may be used as long as electric charge can be transferred from a flying capacitor as a charge transferring source to a flying capacitor as a charge transferring destination.

The term "configured" is used to describe a component, section or part of a device includes hardware and/or software that is constructed and/or programmed to carry out the desired function.

## Claims

1. A battery voltage controller (1) comprising:

   a plurality of voltage detection circuits (D1 to DN) respectively including a plurality of voltage detection capacitors, each of the voltage detection circuits being configured to output a voltage between terminals of one of the voltage detection capacitors after the voltage detection capacitors are respectively charged by a plurality of battery cells;
   a voltage controller (M) configured to obtain output voltages of the voltage detection circuits as results of voltage detection for the battery cells, and perform voltage balance control of the battery cells based on the results of the voltage detection; and
   a charge transfer circuit (E), **characterized in that** the charge transfer circuit (E) is configured to transfer electric charge from one of the voltage detection capacitors to a charge transfer capacitor according to control by the voltage controller, and transfer electric charge from the charge transfer capacitor to another one of the voltage detection capacitors.

2. The battery voltage controller according to claim 1, wherein if a first battery cell of the battery cells is higher in cell voltage than other battery cells of the battery cells as the results of the voltage detection, the voltage controller is configured to determine, as a charge transferring source, a first voltage detection capacitor of the voltage detection capacitors which is charged by the first battery cell, and control the charge transfer circuit to transfer electric charge from the first voltage detection capacitor to the charge transfer capacitor.

3. The battery voltage controller according to claim 2, wherein the voltage controller is configured to monitor a voltage between terminals of the charge transfer capacitor, and
   if a voltage between terminals of the first voltage detection capacitor is higher than the voltage between the terminals of the charge transfer capacitor, the voltage controller is configured to control the charge transfer circuit to transfer the electric charge from the first voltage detection capacitor to the charge transfer capacitor.

4. The battery voltage controller according to claim 1, wherein if a second battery cell of the battery cells is lower in cell voltage than other battery cells of the battery cells as the results of the voltage detection, the voltage controller is configured to determine, as a charge transferring destination, a second voltage detection capacitor of the voltage detection capacitors which is charged by the second battery cell, and control the charge transfer circuit to transfer electric charge from the charge transfer capacitor to the second voltage detection capacitor.

5. The battery voltage controller according to claim 4, wherein the voltage controller is configured to monitor a voltage between terminals of the charge transfer capacitor, and
   if a voltage between terminals of the second voltage detection capacitor is lower than the voltage between the terminals of the charge transfer capacitor, the voltage controller is configured to control the charge transfer circuit to transfer the electric charge from the charge transfer capacitor to the second voltage detection capacitor.

6. The battery voltage controller according to any one of claims 1 to 5, wherein one of the terminals of the charge transfer capacitor which is on a high potential side is connected to a power voltage line via a regeneration switch, and

the voltage controller is configured to control the regeneration switch to be on-state if the voltage controller determines, based on the results of the voltage detection, that all of the battery cells are fully charged.

**Patentansprüche**

1. Batteriespannungsregler (1), umfassend:

    eine Mehrzahl von Spannungserfassungsschaltkreisen (D1 bis DN), jeweils eine Mehrzahl von Spannungserfassungskondensatoren einschließend, wobei jeder der Spannungserfassungsschaltkreise so konfiguriert ist, dass er eine Spannung zwischen Anschlüssen eines der Spannungserfassungskondensatoren ausgibt, nachdem die Spannungserfassungskondensatoren jeweils geladen sind durch eine Mehrzahl von Batteriezellen; einen Spannungsregler (M), der so konfiguriert ist, dass er Ausgangsspannungen der Spannungserfassungsschaltkreise als Resultate von Spannungserfassung für die Batteriezellen erhält, und dass er eine Spannungsausgleichsregelung der Batteriezellen ausführt basierend auf den Ergebnissen der Spannungserfassung; und einen Ladungstransferschaltkreis (E), **dadurch gekennzeichnet dass** der Ladungstransferschaltkreis (E) so konfiguriert ist, dass er elektrische Ladung von einem der Spannungserfassungskondensatoren auf einen Ladungstransferkondensator transferiert gemäß einer Regelung durch den Spannungsregler, und dass er elektrische Ladung von dem Ladungstransferkondensator auf einen anderen der Spannungserfassungskondensatoren transferiert.

2. Batteriespannungsregler nach Anspruch 1, wobei, falls eine erste Batteriezelle von den Batteriezellen eine höhere Zellenspannung hat als andere Batteriezellen von den Batteriezellen als Resultate der Spannungserfassung, der Spannungsregler so konfiguriert ist, dass er, als ladungstransferierende Quelle, einen ersten Spannungserfassungskondensator von den Spannungserfassungskondensatoren bestimmt, welcher durch die erste Batteriezelle geladen ist, und dass er den Ladungstransferschaltkreis so regelt, dass elektrische Ladung von dem ersten Spannungserfassungskondensator auf den Ladungstransferkondensator transferiert wird.

3. Batteriespannungsregler nach Anspruch 2, wobei der Spannungsregler so konfiguriert ist, dass er eine Spannung zwischen Anschlüssen des Ladungstransferkondensators überwacht, und, falls eine Spannung zwischen Anschlüssen des ersten Spannungserfassungskondensators höher ist als die Spannung zwischen den Anschlüssen des Ladungstransferkondensators, der Spannungsregler so konfiguriert ist, dass er den Ladungstransferschaltkreis so regelt, dass er die elektrische Ladung von dem ersten Spannungserfassungskondensator auf den Ladungstransferkondensator transferiert.

4. Batteriespannungsregler nach Anspruch 1, wobei, falls eine zweite Batteriezelle von den Batteriezellen eine niedrigere Zellenspannung als andere Batteriezellen von den Batteriezellen hat als Resultate der Spannungserfassung, der Spannungsregler so konfiguriert ist ,dass er als Ladungstransferziel einen zweiten Spannungserfassungskondensator von den Spannungserfassungskondensatoren bestimmt, welcher durch die zweite Batteriezelle geladen ist, und dass er den Ladungstransferschaltkreis so regelt, dass er elektrische Ladung von dem Spannungserfassungskondensator auf den zweiten Ladungstransferkondensator transferiert.

5. Batteriespannungsregler nach Anspruch 4, wobei der Spannungsregler so konfiguriert ist, dass er eine Spannung zwischen Anschlüssen des Ladungstransferkondensators überwacht, und, falls eine Spannung zwischen Anschlüssen des zweiten Spannungserfassungskondensators niedriger ist als die Spannung zwischen den Anschlüssen des Ladungstransferkondensators, der Spannungsregler so konfiguriert ist, dass er den Ladungstransferschaltkreis so regelt, dass er die elektrische Ladung von dem Spannungserfassungskondensator auf den zweiten Ladungstransferkondensator transferiert.

6. Batteriespannungsregler nach einem der Ansprüche 1 bis 5, wobei einer der Anschlüsse des Ladungstransferkondensators, der auf einer hohen Potentialseite ist, mit einer Spannungsleitung durch eine Regenerationsschaltstufe verbunden ist, und der Spannungsregler so konfiguriert ist, dass er die Regenerationsschaltstufe so regelt, dass sie im Ein-Zustand ist, falls der Spannungsregler bestimmt, basierend auf den Resultaten der Spannungserfassung, dass alle der Batteriezellen vollständig geladen sind.

**Revendications**

1. Contrôleur de tension de batterie (1) comprenant :

   une pluralité de circuits de détection de tension (D1 à DN) comprenant respectivement une pluralité de condensateurs de détection de tension, chacun des circuits de détection de tension étant configuré pour délivrer en sortie une tension entre des bornes d'un des condensateurs de détection de tension après que les condensateurs de détection de tension sont chargés respectivement par une pluralité d'éléments de batterie ;
   un contrôleur de tension (M) configuré pour obtenir des tensions de sortie des circuits de détection de tension comme des résultats de détection de tension pour les éléments de batterie et effectuer une commande d'équilibrage de tension des éléments de batterie sur la base des résultats de la détection de tension ; et
   un circuit de transfert de charge (E), **caractérisé en ce que** le circuit de transfert de charge (E) est configuré pour transférer une charge électrique d'un des condensateurs de détection de tension à un condensateur de transfert de charge en fonction d'une commande par le contrôleur de tension et transférer une charge électrique du condensateur de transfert de charge à un autre des condensateurs de détection de tension.

2. Contrôleur de tension de batterie selon la revendication 1, dans lequel, si un premier élément de batterie des éléments de batterie a une tension d'élément supérieure à d'autres éléments de batterie des éléments de batterie comme résultat de la détection de tension, le contrôleur de tension est configuré pour déterminer, comme une source de transfert de charge, un premier condensateur de détection de tension des condensateurs de détection de tension qui est chargé par le premier élément de batterie, et commander le circuit de transfert de charge pour transférer une charge électrique du premier condensateur de détection de tension au condensateur de transfert de charge.

3. Contrôleur de tension de batterie selon la revendication 2, dans lequel le contrôleur de tension est configuré pour surveiller une tension entre des bornes du condensateur de transfert de charge, et
   si une tension entre les bornes du premier condensateur de détection de tension est supérieure à la tension entre les bornes du condensateur de transfert de charge, le contrôleur de tension est configuré pour commander le circuit de transfert de charge pour transférer la charge électrique du premier condensateur de détection de tension au condensateur de transfert de charge.

4. Contrôleur de tension de batterie selon la revendication 1, dans lequel , si un deuxième élément de batterie des éléments de batterie a une tension d'élément inférieure à d'autres éléments de batterie des éléments de batterie comme résultat de la détection de tension, le contrôleur de tension est configuré pour déterminer, comme une destination de transfert de charge, un deuxième condensateur de détection de tension des condensateurs de détection de tension qui est chargé par le deuxième élément de batterie, et commander le circuit de transfert de charge pour transférer une charge électrique du condensateur de transfert de charge au deuxième condensateur de détection de tension.

5. Contrôleur de tension de batterie selon la revendication 4, dans lequel le contrôleur de tension est configuré pour surveiller une tension entre des bornes du condensateur de transfert de charge, et
   si une tension entre les bornes du deuxième condensateur de détection de tension est inférieure à la tension entre les bornes du condensateur de transfert de charge, le contrôleur de tension est configuré pour commander le circuit de transfert de charge pour transférer la charge électrique du condensateur de transfert de charge au deuxième condensateur de détection de tension.

6. Contrôleur de tension de batterie selon l'une quelconque des revendications 1 à 5, dans lequel une des bornes du condensateur de transfert de charge qui est sur un côté haut potentiel est connectée à une ligne de tension d'alimentation via un commutateur de régénération, et
   le contrôleur de tension est configuré pour commander le commutateur de régénération pour être dans un état activé si le contrôleur de tension détermine, sur la base des résultats de la détection de tension, que tous les éléments de batterie sont complètement chargés.

# FIG. 1

## FIG. 2A

## FIG. 2B

FIG. 3A

FIG. 3B

## FIG. 4A

## FIG. 4B

**EP 2 506 390 B1**

### Patent documents cited in the description

- JP 2008021589 A
- JP 2010088179 A
- US 2009309545 A
- US 2004246635 A